# EUROPEAN PATENT APPLICATION

(11) **EP 4 503 109 A1**
(43) Date of publication of application: **05.02.2025**
(21) Application number: 23779969.7
(22) Date of filing: 22.03.2023
(51) Int. Cl.: H01L 21/683

(54) **PLACEMENT MEMBER**

(30) Priority: 30.03.2022 JP 2022056482
(71) Applicant: Kyocera Corporation, Kyoto-shi, Kyoto 612-8501 (JP)
(72) Inventor: AKASHI, Koji, Kyoto-shi, Kyoto 612-8501 (JP)
(74) Representative: Viering, Jentschura & Partner mbB Patent- und Rechtsanwälte
(86) International application number: PCT/JP2023/011285
(87) International publication number: WO 2023/189957

(57) **Abstract**

A placement member according to the present disclosure includes a base portion having a flat plate shape and a plurality of protruding portions on a main surface of the base portion. Each of the protruding portions includes a placement surface on which a to-be-inspected object or a to-be-treated object is placed. The placement surface includes a concave inner peripheral side curved surface and an outer peripheral side convex portion connected to the inner peripheral side curved surface.

## Description

### TECHNICAL FIELD

The present invention relates to a placement member.

### BACKGROUND OF INVENTION

In recent years, in a semiconductor manufacturing process, improvement of an etching technique has been required along with high integration and high performance of a semiconductor element. In a semiconductor manufacturing device such as a plasma etching device, for example, an electrostatic chuck device as described in Patent Document 1 is used as a device for maintaining a wafer at a desired temperature after placing and fixing the wafer on a sample stage.

However, in the conventional electrostatic chuck device described in Patent Document 1, the entire top surface of a protruding portion is in contact with the back surface of the wafer. Thus, when particles are present between the top surface of the protruding portion and the back surface of the wafer, the particles may adhere to the back surface of the wafer. When the particles adhere to the back surface of the wafer, the wafer is easily damaged.

### CITATION LIST

### PATENT LITERATURE

Patent Document 1: JP 2016-139650 A

### SUMMARY

### SOLUTION TO PROBLEM

A placement member according to the present disclosure includes a base portion having a flat plate shape and a plurality of protruding portions on a main surface of the base portion. Each of the protruding portions includes a placement surface on which a to-be-inspected object or a to-be-treated object is placed. The placement surface includes a concave inner peripheral side curved surface and an outer peripheral side convex portion connected to the inner peripheral side curved surface.

A manufacturing method of a placement member according to one embodiment of the present disclosure includes: granulating raw material powder milled until an average particle diameter (D50) becomes 1.5 µm or less to obtain granules; filling a molding die with the granules and obtaining a plate-shaped powder compact using a cold isostatic pressing method; firing the plate-shaped powder compact to obtain a plate-shaped body; forming a mask on one main surface of the plate-shaped body at a portion to be the protruding portion, and then performing blasting to form a concave portion and a convex portion which is a remaining portion of the concave portion; grinding or polishing a top surface of the convex portion; and heat-treating the plate-shaped body in an air atmosphere.

An exposure device according to one embodiment of the present disclosure includes: a station configured to store a cassette accommodating the placement member described above; an adsorbing portion configured to position the placement member; an exposure stage configured to perform an exposure treatment on the to-be-treated object; a first transfer member configured to take out the placement member from the cassette and then transfer the placement member to the adsorbing portion; and a second transfer member configured to convey the placement member from the adsorbing portion to the exposure stage.

### BRIEF DESCRIPTION OF THE DRAWINGS

FIG. 1 is a schematic view illustrating a main portion of a placement member according to one embodiment of the present disclosure.
FIG. 2 is an electron micrograph of one of protruding portions illustrated in FIG. 1.
FIG. 3 is a schematic view schematically illustrating the protruding portion illustrated in FIG. 2.
FIG. 4 is a graph showing a profile of the protruding portion illustrated in FIG. 2.
FIG. 5 is a plan view of a substrate holding tool using a placement member according to another embodiment of the present disclosure.
FIG. 6 is a cross-sectional view for explaining a cross section taken along line A-A' illustrated in FIG. 5.

### DESCRIPTION OF EMBODIMENTS

In the conventional electrostatic chuck device described in Patent Document 1, as described above, the entire top surface of the protruding portion is in contact with the back surface of the wafer. Thus, when particles are present between the top surface of the protruding portion and the back surface of the wafer, the particles may adhere to the back surface of the wafer. When the particles adhere to the back surface of the wafer, the wafer is easily damaged.

Since the placement member according to the present disclosure has the above-described configuration, adhesion of particles to the back surface of a to-be-inspected object or a to-be-treated object such as a semiconductor wafer can be reduced.

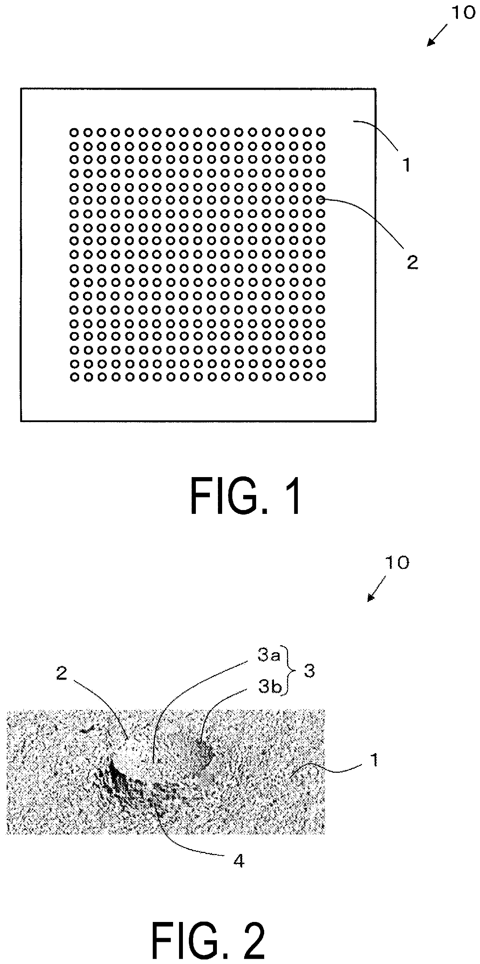

A placement member according to one embodiment of the present disclosure will be described with reference to FIGs. 1 to 6. A placement member 10 according to one embodiment illustrated in FIG. 1 includes a base portion 1 and a plurality of protruding portions 2. FIG. 1 is a schematic view illustrating a main portion of the placement member 10 according to one embodiment.

The base portion 1 is not limited as long as it has a flat plate shape, and a thickness, a size, and the like are appropriately set according to a device or the like provided with the placement member 10. The base portion 1 may have a quadrilateral shape or a circler shape in a plan view.

The base portion 1 is formed of, for example, a ceramic. A ceramic forming the base portion 1 may be, for example, a ceramic having aluminum oxide, silicon carbide, or silicon carbonitride as a main component. A ceramic containing any one of these components as a main component has good wear resistance and can be used for a long period of time.

In the present specification, the "main component" means a component contained in a proportion of 80 mass% or more when the total of the components constituting a ceramic is 100 mass%. The identification of each component contained in the ceramic may be performed with an X-ray diffractometer using a CuKα beam, and the content of each component may be determined, for example, with an Inductively Coupled Plasma (ICP) emission spectrophotometer or a fluorescence X-ray spectrometer.

The plurality of protruding portions 2 are located on a main surface of the base portion 1 as illustrated in FIG. 1. The protruding portion 2 is also formed of a ceramic having aluminum oxide, silicon carbide, or silicon carbonitride as a main component, as with the base portion 1. The base portion 1 and the protruding portion 2 are integrally molded from, for example, a raw material having the same main component.

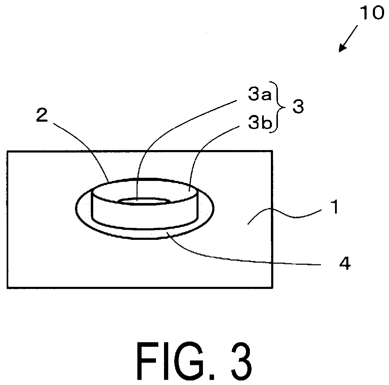

As illustrated in FIGs. 2 and 3, the protruding portion 2 includes a placement surface 3 on which a to-be-inspected object or a to-be-treated object (hereinafter, the to-be-inspected object or the to-be-treated object may be collectively referred to as a to-be-placed object) is placed. The inspection object is, for example, a semiconductor wafer on which a plurality of semiconductor chips are formed or another electronic device, and its electrical characteristics are to be inspected. The to-be-treated object is, for example, a semiconductor wafer on which various kinds of treatment such as an exposure treatment and a film forming treatment are performed. FIG. 2 is an electron micrograph showing one of the protruding portions illustrated in FIG. 1. FIG. 3 is a schematic view of the protruding portion illustrated in FIG. 2. The placement surface 3 includes an inner peripheral side curved surface 3a and an outer peripheral side convex portion 3b.

The inner peripheral side curved surface 3a has a concave shape and is a recessed portion on the inner side of the placement surface 3. The inner peripheral side curved surface 3a is not limited as long as it is slightly recessed in a concave shape, and the depth of the concave portion is appropriately set according to the height of the protruding portion 2. The average value of the maximum depth of the inner peripheral side curved surface 3a starting from the top surface of the outer peripheral side convex portion 3b described later may be 20 µm or more and 50 µm or less. The coefficient of variation of the maximum depth of the inner peripheral side curved surface 3a starting from the top surface of the outer peripheral side convex portion 3b may be 0.02 or less. When the coefficient of variation is 0.02 or less, the depth of the inner peripheral side curved surface 3a is substantially constant, causing little variation in depth. Since the inner peripheral side curved surface 3a has a concave shape, it does not come into contact with the to-be-placed object.

The outer peripheral side convex portion 3b is a portion connected to the inner peripheral side curved surface 3a. Specifically, the outer peripheral side convex portion 3b corresponds to an outer wall surface for forming the inner peripheral side curved surface 3a. The top surface of the outer peripheral side convex portion 3b is a portion that comes into contact with the to-be-placed object. The inner peripheral side curved surface 3a means a curved surface included in a region within 2/3 of the maximum depth from the deepest position of the concave portion toward the upper side perpendicular to the main surface. The outer peripheral side convex portion 3b means an outer region which is connected to the inner peripheral side curved surface 3a and deviates from the above-described 2/3.

Since the placement surface 3 includes the inner peripheral side curved surface 3a and the outer peripheral side convex portion 3b, the placement member 10 can support the to-be-placed object by the outer peripheral side convex portion 3b. As a result, the contact surface area between the back surface of the to-be-treated object and the placement surface 3 is reduced, thus reducing the adhesion of particles caused by the contact with the back surface of the to-be-placed object. Even when fine particles are accumulated on the inner peripheral side curved surface 3a, the adhesion of the particles to the back surface can be reduced by the gap generated between the inner peripheral side curved surface 3a and the back surface of the to-be-placed object. Since the outer peripheral side convex portion 3b is connected to the inner peripheral side curved surface 3a, stress concentrations on the inner side of the outer peripheral side convex portion 3b can be reduced. As a result, even when repeatedly exposed to a high-temperature environment and a low-temperature environment, cracks starting from the inner peripheral side curved surface 3a or the outer peripheral side convex portion 3b are unlikely to occur.

As illustrated in FIGs. 2 and 3, an annular recessed portion 4 extending in the depth direction from the main surface of the base portion 1 may be provided around the protruding portion 2. The radial width of the recessed portion 4 is preferably smaller than the equivalent circle diameter of the outer peripheral side convex portion 3b. The depth of the recessed portion 4 is appropriately set in accordance with the thickness of the base portion 1 so as not to penetrate the base portion 1.

By providing this recessed portion 4, the placement member 10 can easily capture floating particles by the recessed portion 4. The captured particles can be suppressed from floating again. When the radial width of the recessed portion 4 is smaller than the equivalent circle diameter of the outer peripheral side convex portion 3b, the volume of the recessed portion 4 is suppressed. As a result, rigidity of the base portion 1 can also be maintained.

The average value of the curvatures of the inner peripheral side curved surface 3a is not limited, and may be, for example, 0.004 (1/µm) or more and 0.008 (1/µm) or less. This curvature is a value approximated by the least square method. When the average value of the curvatures of the inner peripheral side curved surface 3a is 0.004 (1/µm) or more, the depth of the deepest portion of the inner peripheral side curved surface 3a becomes deep. Therefore, capacity for accommodating fine particles increases. As a result, particles adhering to the back surface of the to-be-placed object can be further reduced. On the other hand, when the average value of the curvatures of the inner peripheral side curved surface 3a is 0.008 (1/µm) or less, the thickness of the base portion 1 from the back surface is sufficiently ensured. As a result, rigidity of the base portion 1 can be maintained more efficiently. As described above, by setting the average value of the curvatures of the inner peripheral side curved surface 3a to 0.004 (1/µm) or more and 0.008 (1/µm) or less, the adhesion of particles to the back surface of the to-be-placed object can be reduced while maintaining the rigidity of the base portion 1.

The upper surface of the outer peripheral side convex portion 3b includes a top surface in contact with the to-be-placed object, and may be flat or curved. In particular, when the upper surface of the outer peripheral side convex portion 3b is curved, the contact surface area between the to-be-placed object and the top surface of the outer peripheral side convex portion 3b is reduced. As a result, the adhesion of particles caused by the contact between the back surface of the to-be-placed object and the top surface of the outer peripheral side convex portion 3b can be further reduced.

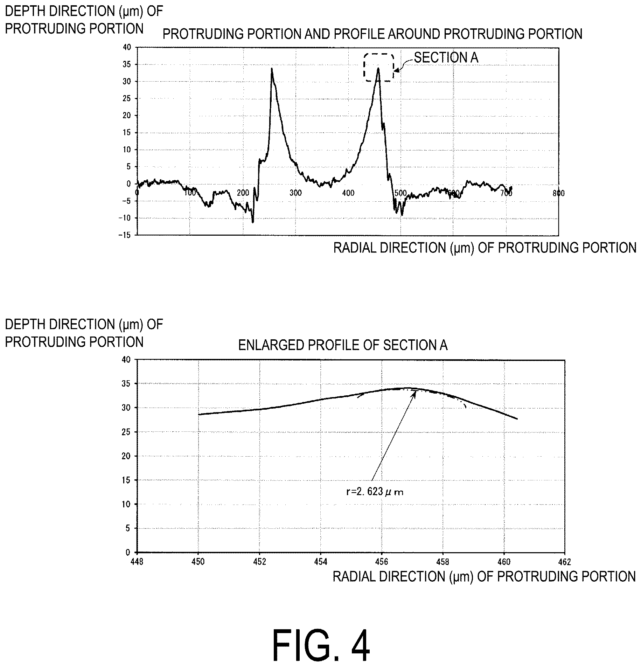

FIG. 4 is a graph showing a profile of the protruding portion 2 illustrated in FIG. 2. As illustrated in FIG. 4, from the profile obtained by enlarging the upper surface (portion A in the graph) of the outer peripheral side convex portion 3b, it can be seen that the upper surface of the outer peripheral side convex portion 3b is curved.

When the upper surface of the outer peripheral side convex portion 3b is curved, the average value of the curvatures of the upper surface of the outer peripheral side convex portion 3b may be larger than the average value of the curvatures of the inner peripheral side curved surface 3a. When the average value of the curvatures of the upper surface of the outer peripheral side convex portion 3b is larger than the average value of the curvatures of the inner peripheral side curved surface 3a, the stress concentration on the inner peripheral side curved surface 3a can be reduced, and the contact surface area between the outer peripheral side convex portion 3b and the to-be-placed object can also be reduced.

When the upper surface of the outer peripheral side convex portion 3b is curved, the average value of the curvatures of the upper surface may be 0.1 (1/µm) or more and 10 (1/µm) or less. This curvature is a value approximated by the least square method. When the average value of the curvatures of the upper surface is 0.1 (1/µm) or more, the contact surface area between the back surface of the to-be-placed object and the top surface of the outer peripheral side convex portion 3b becomes smaller. As a result, the adhesion of particles caused by the contact between the back surface of the to-be-placed object and the top surface of the outer peripheral side convex portion 3b can be further reduced. On the other hand, when the average value of the curvatures of the upper surface is 10 (1/µm) or less, particle dropping from the outer peripheral side convex portion 3b caused by contact between the back surface of the to-be-placed object and the top surface of the outer peripheral side convex portion 3b can be reduced. As a result, the possibility that the particles floating due to the dropping adhere to the to-be-placed object is reduced.

Curvatures of the inner peripheral side curved surface 3a and the upper surface of the outer peripheral side convex portion 3b can be measured using a shape analysis laser microscope (available from KEYENCE Corporation, ultra-deep color 3D shape measuring microscope (VK-X1100 or successor models thereof)). The profile measurement may be performed for each measurement range by setting the measurement conditions that an illumination method is coaxial illumination and a magnification is 480 times, setting the measurement range including the inner peripheral side curved surface 3a and the upper surface the outer peripheral side convex portion 3b to be measured to, for example, 710 µm × 533 µm per location, and drawing a line to be measured on the diameter of protruding portion 2. The length per line to be measured is, for example, 200 µm or more and 300 µm or less, and corresponds to the equivalent circular diameter of the outer peripheral side convex portion 3b. At least eight measurement ranges are set, and the number of lines to be measured is 8 in total in this case. The curvatures of the inner peripheral side curved surface 3a and the upper surface of the outer peripheral side convex portion 3b are obtained from the measured values of the eight lines, and the respective average values may be calculated.

The cut level difference (Rδc1) representing the difference between the cut level at a load length ratio of 25% on the roughness curve of the outer peripheral side convex portion 3b and the cut level at a load length ratio of 75% on the roughness curve may be 0.7 µm or less (excluding 0 µm). When the cut level difference (Rδc1) is 0.7 µm or less, the particle dropping from the outer peripheral side convex portion 3b is further reduced. As a result, the possibility that the particles floating due to the dropping adhere to the to-be-placed object is further reduced.

The cut level difference (Rδc1) can be measured by using a shape analysis laser microscope (available from KEYENCE Corporation, ultra-deep color 3D shape measuring microscope (VK-X1000 or successor models thereof)) in accordance with JIS B 0601-2001. As measurement conditions, an illumination method is set to coaxial illumination, a magnification is set to 480 times, a cutoff value λs is set to none, a cutoff value λc is set to 0.08 mm, a termination effect correction is set to presence, and a measurement range per location is set to 710 µm × 533 µm.

In each measurement range, a circumference to be measured may be drawn along the upper surface of the outer peripheral side convex portion 3b on the inner peripheral side curved surface 3a side, and the line roughness may be measured. The length per circumference to be measured is, for example, 460 µm. At least eight measurement ranges are set, and the number of lines to be measured is 8 in total in this case.

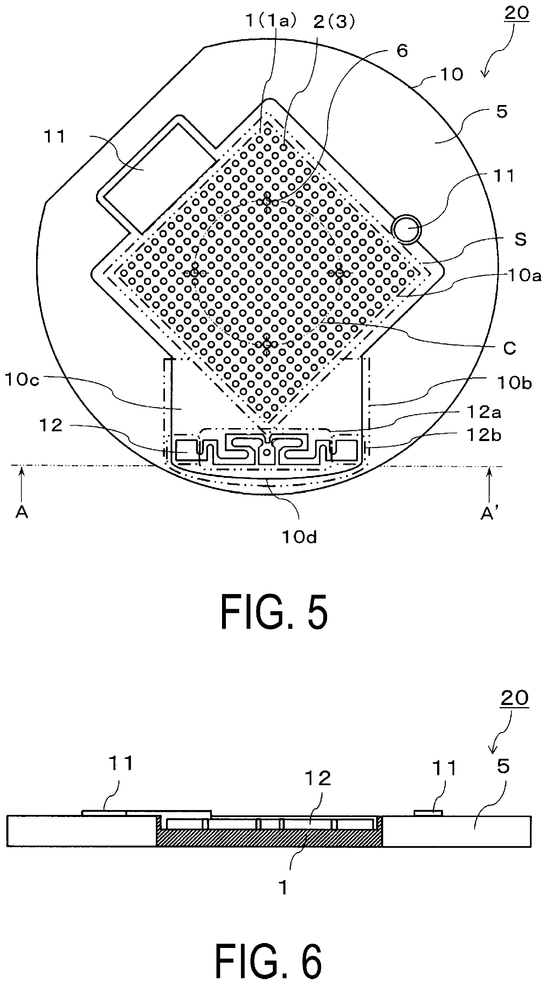

A substrate holding tool 20 illustrated in FIGs. 5 and 6 includes a placement member 10 on which a rectangular plate-shaped to-be-treated object S (indicated by a long two dot chain line in FIG. 5) is placed, a substrate contact portion 11, and a pressing member 12.

The placement member 10 includes the base portion 1 having a flat plate shape and the plurality of protruding portions 2 on a main surface 1a of the base portion 1, the protruding portion 2 includes the placement surface 3 for placing the to-be-treated object S, and the plurality of protruding portions 2 are surrounded by an outer peripheral portion 5. The to-be-treated object S is sucked and placed on the placement surface 3 by being exhausted from a plurality of exhaust holes 6 disposed at equal intervals along a virtual circumference C in a first region 10a including the plurality of protruding portions 2.

The substrate contact portion 11 comes into contact with a side surface of the to-be-treated object S to position the to-be-treated object S. In FIG. 5, the substrate contact portion 11 has a pin shape or a rectangular plate shape. However, the substrate contact portion 11 is not limited to these shapes, and may be an inner surface itself of a concave portion provided in the placement member 10, a projecting portion projecting from the inner surface, or the like.

The pressing member 12 is also referred to as a leaf spring and includes a deformation portion 12a and two fixing portions 12b. The deformation portion 12a includes a facing surface facing the to-be-treated object S and is elastic in the vertical direction in FIG. 5. The two fixing portions 12b are connected to the deformation portion 12a and are located on two sides of the deformation portion 12a so as to be separated from each other.

The placement member 10 includes a second region 10b on which the pressing member 12 is mounted, the second region 10b includes a stepped surface 10c located at a position lower than the placement surface 3 and an inner side surface 10d intersecting with the stepped surface 10c, and at least a portion of the inner side surface 10d facing the deformation portion 12a may be curved downward.

A cut level difference (Rδc2) representing a difference between a cut level at a load length ratio of 25% in the roughness curve of the main surface of the base portion 1 and a cut level at a load length ratio of 75% in the roughness curve and a cut level difference (Rδc3) representing a difference between a cut level at a load length ratio of 25% in the roughness curve of the upper surface of the outer peripheral portion 5 and a cut level at a load length ratio of 75% in the roughness curve may both be 0.2 µm or more and 2.2 µm or less. When the cut level difference (Rδc2) and the cut level difference (Rδc3) are in this range, the particle dropping from the main surface of the base portion 1 and the upper surface of the outer peripheral portion 5 is further reduced. As a result, the possibility that the particles floating due to the dropping adhere to the to-be-treated object can be further reduced.

The cut level differences (Rδc2) and (Rδc3) can be measured by using a shape analysis laser microscope (available from KEYENCE Corporation, ultra-deep color 3D shape measuring microscope (VK-X1000 or successor models thereof)) in accordance with JIS B 0601-2001. As measurement conditions, an illumination method is set to coaxial illumination, a magnification is set to 240 times, a cutoff value λs is set to none, a cutoff value λc is set to 0.08 mm, a termination effect correction is set to presence, and a measurement range per location is set to 1428 µm × 1070 µm.

The line roughness may be measured by drawing, in each measurement range, four straight lines to be measured along a longitudinal direction of the measurement range. The length per straight line to be measured is, for example, 1280 µm. At least three measurement ranges are set, and the number of lines to be measured is 12 in total in this case.

The manufacturing method of the placement member according to the present disclosure is not limited. For example, the placement member according to the present disclosure can be obtained by the following steps (a) to (f).
Step (a): Granulating raw material powder milled until the average particle diameter (D₅₀) becomes 1.5 µm or less to obtain granules.
Step (b): Filling a molding die with the granules and obtaining a plate-shaped powder compact using a cold isostatic pressing method.
Step (c): Firing the plate-shaped powder compact to obtain a plate-shaped body.
Step (d): Forming a mask on one main surface of the plate-shaped body at a portion to be the protruding portion, and then performing blasting to form a concave portion and a convex portion which is a remaining portion of the concave portion.
Step (e): Grinding or polishing the top surface of the convex portion.
Step (f): Heat-treating the plate-shaped body in an air atmosphere.

In step (a), the raw material powder is granulated. The raw material powder may be, for example, powder having a main component including aluminum oxide, silicon carbide, or silicon carbonitride. When the powder as the main component is aluminum oxide (having a purity of 99.9 mass% or more), each powder of magnesium hydroxide, silicon oxide, and calcium carbonate is fed into a mill together with a solvent (ion exchange water) and ground until the average particle diameter (D₅₀) becomes 1.5 µm or less. Here, of the total of 100 mass% of the powder described above, the content of magnesium hydroxide powder falls in a range of 0.43 mass% or more and 0.53 mass% or less; the content of silicon oxide powder falls in a range of 0.02 mass% or more and 0.04 mass% or less; the content of calcium carbonate powder falls in a range of 0.02 mass% or more and 0.071 mass% or less; and the remainder includes aluminum oxide powder and inevitable impurities.

After an organic binder and a dispersing agent for dispersing the aluminum oxide powder are added and mixed to the milled powder to obtain a slurry, the slurry may be granulated using a granulator such as a rolling granulator, a spray granulator, or a compression granulator. Examples of the spray granulator include a nozzle spray granulator and a disk spray granulator. The average particle diameter (D₅₀) after granulation is not limited, and may be 50 µm or more and 150 µm or less, for example. Examples of the organic binder include acrylic emulsions, polyvinyl alcohol, polyethylene glycol, polyethylene oxide.

In step (b), the granules obtained in step (a) are molded to obtain a plate-shaped powder compact. The molding is performed using the cold isostatic pressing method. Molding pressure is, for example, 78 MPa or more and 196 MPa or less.

Next, in step (c), the plate-shaped powder compact obtained in step (b) is fired to obtain a plate-shaped body. The firing is performed, for example, in an air atmosphere at 1500°C or more and 1700°C or less for 4 hours or more and 6 hours or less. In this way, a plate-shaped body formed of ceramics is obtained. The plate-shaped body formed of ceramic is subjected to the following steps (d) and (e) to form the base portion 1 and the protruding portion 2.

In step (d), a concave portion and a convex portion which is a remaining portion of the concave portion are formed on one main surface of the plate-shaped body obtained in step (c). Specifically, on one main surface of the obtained plate-shaped body, a mask is formed at a portion to be the protruding portion 2, and then blasting may be performed. The blasting time is, for example, 10 minutes or more and 20 minutes or less. In the case of blasting, silicon carbide abrasive grains having a grain size number of F80, F90, F100 or F120 described in JIS R 6001-1:2017 (ISO 8486-1:1996) may be used. By performing blasting, the inner bottom surface of the concave portion becomes the main surface of the base portion 1, and the convex portion becomes a precursor of the protruding portion 2. The outer peripheral side of the concave portion is an outer peripheral portion surrounding the plurality of protruding portions 2.

As illustrated in FIGs. 2 and 3, when obtaining the placement member 10 including the recessed portion 4, after the convex portion is formed by blasting, the periphery of the convex portion is altered by adjusting the blasting conditions so as to leave an altered layer around the convex portion, such as by subjecting the periphery of the convex portion to blasting at a low output for a long period of time, for example, 15 minutes or more.

Next, in step (e), the top surface of the convex portion formed in step (d) is ground or polished. The grinding is performed by using, for example, a flat surface grinder using a diamond grindstone. On the other hand, polishing is performed by using, for example, a double-side lapping machine using diamond abrasive grains. When polishing, slurry or paste including diamond abrasive grains having an average particle diameter (D₅₀) of 4 µm or more and 20 µm or more may be supplied to the lapping machine. If necessary, after polishing with diamond abrasive grains having an average particle diameter (D₅₀) of 20 µm, polishing may be sequentially performed with diamond abrasive grains having a smaller average particle diameter (D₅₀), for example, 10 µm and 4 µm. Examples of the lapping machine include cast iron and tin. The upper surface of the outer peripheral portion may be ground or polished together with the top surface of the convex portion.

In step (f), after the top surface of the convex portion is ground or polished in step (e), the plate-shaped body is heat-treated in the air atmosphere. Conditions of the heat treatment is not limited; for example, the heat treatment may be performed in the air atmosphere at a temperature of 1300°C or more and 1500°C or less for 1 hour or more and 3 hours or less. By altering the periphery of the convex portion in step (d), the periphery of the convex portion undergoes stress relaxation and accompanying deformation during the heat treatment in step (f). As a result, the protruding portion including the placement surface including the inner peripheral side curved surface and the outer peripheral side convex portion can be obtained.

When the placement member 10 is a non-oxide member (such as a ceramic containing silicon carbide or silicon carbonitride as a main component), an oxide layer is formed on the surface of the placement member 10 by performing step (f) in the air atmosphere, whereby particle reduction can be improved. When the placement member 10 is an oxide member (such as aluminum oxide), alteration (reduction) of the surface of the placement member 10 can be suppressed and stress relaxation can be promoted.

Note that, in step (e) described above, the heights of the top surfaces of the plurality of convex portions may be aligned with high accuracy, and thereafter, after step (f) is performed to form the protruding portions, the top surfaces of the protruding portions may not be ground or polished. In this case, if the placement member 10 is a non-oxide member, the oxide layer on the surface formed in step (f) is not removed but maintained. Thus, particle reduction can be improved. When the placement member 10 is an oxide member, in step (f), a portion where alteration (reduction) of the surface is suppressed and the stress relaxation is promoted is not removed but maintained. As a result, deterioration reduction and particle reduction can be improved.

In this way, the placement member 10 according to one embodiment including the base portion 1 and the plurality of protruding portions 2 is obtained. In step (d), the periphery of the convex portion is altered, and the alteration is used to form the protruding portion including the placement surface including the inner peripheral side curved surface and the outer peripheral side convex portion, but the present disclosure is not limited to this configuration. For example, the periphery of the convex portion may not be altered in step (d), and the top surface of the convex portion may be ground or polished using a tool having a round tip to recess the top surface of the convex portion in step (e), thereby forming the protruding portion including the placement surface including the inner peripheral side curved surface and the outer peripheral side convex portion.

In step (d) described above, the convex portion is formed by blasting, but the present disclosure is not limited thereto, and the convex portion may be formed by laser machining, for example. That is, in step (d), after the convex portion is formed by blasting or laser machining, blasting may be performed at a low output for a long time to alter the periphery of the convex portion. In step (d), after the convex portion is formed by blasting or laser machining, the top surface of the convex portion may be recessed by grinding or polishing using a tool having a round tip. The placement member 10 according to one embodiment is used as, for example, a member of a semiconductor manufacturing device such as an exposure device or a film forming device.

A use example of the placement member 10 according to one embodiment will be described with reference to an exposure device. An exposure device according to one embodiment includes a station, an adsorbing portion, an exposure stage, a first transfer member, and a second transfer member.

The station is a member for storing a cassette accommodating the placement member 10. The adsorbing portion is a member for positioning the placement member 10. The exposure stage is a member for exposing the to-be-treated object. The first transfer member is, for example, a transfer arm which is formed of a plate-shaped body including a support portion supporting the substrate and a holding portion holding the support portion, and a distal end side of the support portion is branched into at least two. The first transfer member is a member that takes out the placement member 10 from the cassette and transfers the placement member 10 to the adsorbing portion after inserting the support portion into the cassette. The second transfer member is a member that transfers the placement member 10 transferred to the adsorbing portion to the exposure stage.

The placement member according to the present disclosure is not limited to the placement member 10 described above. For example, the placement member 10 described above includes the recessed portion 4 around the protruding portion 2. However, the placement member according to the present disclosure need not include the recessed portion 4.

### REFERENCE SIGNS

1 Base portion
2 Protruding portion
3 Placement surface
3a Inner peripheral side curved surface
3b Outer peripheral side convex portion
4 Recessed portion
5 Outer peripheral portion
6 Exhaust hole
10 Placement member
11 Substrate contact portion
12 Pressing member
20 Substrate holding tool

## Claims

1. A placement member comprising:
a base portion having a flat plate shape; and
a plurality of protruding portions on a main surface of the base portion, wherein
the protruding portion has a placement surface for placing a to-be-inspected object or a to-be-treated object, and
the placement surface comprises an inner peripheral side curved surface having a concave shape and an outer peripheral side convex portion connected to the inner peripheral side curved surface.

2. The placement member according to claim 1, wherein an average value of curvatures of the inner peripheral side curved surface is 0.004 (1/µm) or more and 0.008 (1/µm) or less.

3. The placement member according to claim 1 or 2, wherein an upper surface of the outer peripheral side convex portion is curved.

4. The placement member according to claim 3, wherein an average value of curvatures of the upper surface of the outer peripheral side convex portion is larger than an average value of curvatures of the inner peripheral side curved surface.

5. The placement member according to any of claims 1 to 4, comprising
a recessed portion provided around the protruding portion and having an annular shape extending in a depth direction from the main surface of the substrate,
wherein a radial width of the recessed portion is smaller than an equivalent circle diameter of the outer peripheral side convex portion.

6. A manufacturing method of the placement member according to any one of claims 1 to 5, the method comprising:
granulating raw material powder milled until an average particle diameter (D₅₀) becomes 1.5 µm or less to obtain granules;
filling a molding die with the granules and obtaining a plate-shaped powder compact using a cold isostatic pressing method;
firing the plate-shaped powder compact to obtain a plate-shaped body;
forming a mask on one main surface of the plate-shaped body at a portion to be the protruding portion, and then performing blasting to form a concave portion and a convex portion that is a remaining portion of the concave portion;
grinding or polishing a top surface of the convex portion; and
heat-treating the plate-shaped body in an air atmosphere.

7. An exposure device comprising:
a station configured to store a cassette accommodating the placement member according to any one of claims 1 to 5;
an adsorbing portion configured to position the placement member;
an exposure stage configured to perform an exposure treatment on the to-be-treated object;
a first transfer member configured to take out the placement member from the cassette and then transfer the placement member to the adsorbing portion; and
a second transfer member configured to transfer the placement member from the adsorbing portion to the exposure stage.
